# EUROPÄISCHE PATENTSCHRIFT

(11) **EP 1 329 936 B1**
(45) Veröffentlichungstag und Bekanntmachung des Hinweises auf die Patenterteilung: **29.11.2006**
(21) Anmeldenummer: 02023322.7
(22) Anmeldetag: 18.10.2002
(51) Int. Cl.: H01J 37/26

(54) **Phasenkontrast-Elektronenmikroskop mit ringförmiger Beleuchtungsapertur**
Phase contrast electron microscope with ring-shaped illumination aperture
Microscope électronique à contraste de phase avec ouverture d'illumination annulaire

(30) Priorität: 10.01.2002 DE 10200645
(43) Veröffentlichungstag der Anmeldung: 23.07.2003
(73) Patentinhaber: Carl Zeiss NTS GmbH, 73446 Oberkochen (DE)
(72) Erfinder: Benner, Gerd, Dr., 73434 Aalen (DE)
(74) Vertreter: Gnatzig, Klaus

(56) Entgegenhaltungen:
- US-A- 5 814 815
- MATSUMOTO T ET AL: "THE PHASE CONSTANCY OF ELECTRON WAVES TRAVELING THROUGH BOERSCH'S ELECTROSTATIC PHASE PLATE" ULTRAMICROSCOPY, AMSTERDAM, NL, Bd. 63, Nr. 1, 1. April 1996 (1996-04-01), Seiten 5-10, XP002054177 ISSN: 0304-3991
- DANEV R ET AL: "Transmission electron microscopy with Zernike phase plate" ULTRAMICROSCOPY, Bd. 88, 2001, Seite 243-252 XP001147988 AMSTERDAM
- PATENT ABSTRACTS OF JAPAN vol. 009, no. 118 (E-316), 23. Mai 1985 (1985-05-23) & JP 60 007048 A (HITACHI SEISAKUSHO KK), 14. Januar 1985 (1985-01-14)

## Beschreibung

In der Lichtoptik hat die Phasenkontrast-Mikroskopie große Bedeutung für die Sichtbarmachung von biologischen Strukturen, die keinen oder nur wenig Amplitudenkontrast erzeugen. Die Erzeugung des Phasenkontrastes erfolgt dabei dadurch, daß durch eine Phasenplatte unterschiedlichen Beugungsordnungen der am Objekt gebeugten Strahlung, die aufgrund des Beugungseffektes bereits einen Phasenunterschied von π/2 aufweisen, eine zusätzliche, für die verschiedenen Beugungsordnungen unterschiedliche Phasenverschiebung von ebenfalls π/2 aufgeprägt wird. In der Lichtmikroskopie wird der Phasenkontrast nach Zernike dadurch erzeugt, daß in der Pupillenebene des Kondensors eine Ringblende angeordnet ist und in der austrittsseitigen Brennebene des Mikroskopobjektivs eine Phasenplatte angeordnet ist, die dem Nullstrahl, d.h. dem am Objekt ungebeugten Licht, eine Phasenverschiebung aufprägt, die sich um π/2 von der den höheren Beugungsordnungen aufgeprägten Phasenverschiebung unterscheidet. Diese Methode ist auf die Elektronenoptik nicht einfach übertragbar, da einerseits auf Grund der kleinen Beleuchtungsapertur eine submikroskopische Ringblende im Beleuchtungssystem erforderlich wäre und andererseits kein geeignetes, für Elektronen vollständig transparentes Trägermaterial zur Verfügung steht .

Zur Erzeugung von Phasenkontrast in der Elektronenmikroskopie wurden bereits verschiedene Verfahren vorgeschlagen. Eine Möglichkeit ist es, die phasenschiebende Wirkung des Öffnungsfehlers des Objektivs in Verbindung mit einer Defokussierung des Objektivs auszunutzen. Der dadurch erzeuge Phasenkontrast für einen vorgegebenen Defokus- und Öffnungsfehlerkoeffizienten hängt dabei jedoch von der Raumfrequenz der jeweiligen Bildinformation ab und wird durch die sogenannte "phase contrast transfer function" (PCTF) beschrieben. In der Regel können derartige Phasenkontraste jedoch nur in einem starken Unterfokus sichtbar gemacht werden, in dem die PCTF stark oszilliert, was dann jedoch die Interpretation des erzeugten Bildes sehr schwierig oder gar unmöglich macht.

Weitere Möglichkeit zur Erzeugung von Phasenkontrast in der Elektronenmikroskopie sind in einem Aufsatz von Boersch in Zeitschrift für Naturwissenschaften 2a, 1947, Seite 615 ff. beschrieben. Danach wird die Phasenschiebung des Elektronenstrahls durch äußere elektrische und/oder magnetische Potentiale oder durch Ausnutzung des inneren Potentials beim Durchtritt durch eine dünne Folie ausgenutzt. Beim letzteren Prinzip besteht die Phasenplatte aus einer dünnen Kohlefolie mit einer Dicke von 20nm mit einem zentralen Loch, durch das der Nullstrahl unbeeinflußt hindurch treten kann. Die abgebeugten Strahlen treten durch die Folie und erfahren eine Phasenschiebung um π/2. Dieses Prinzip hat jedoch wesentliche Nachteile. Zum einen muß der Lochdurchmesser des zentralen Loches in der Größenordnung von etwa 1µm liegen, da die Beleuchtungsaperturen und damit die Ausdehnung des Nullstrahles in der Brennebene entsprechend klein ist. Die Herstellung und Zentrierung von derart kleinen Löchern relativ zum Elektronenstrahl ist sehr problematisch. Weiterhin kann sich die Dicke der Folie durch Kontamination stark ändern und das zentrale Loch für den Nullstrahl kann rasch durch Kontamination zuwachsen. Die unvermeidbare elektrische Aufladung der Folie bewirkt eine zusätzliche anisotrope Phasenverschiebung wodurch die insgesamt erzeuge Phasenverschiebung relativ unkontrollierbar wird. Schließlich werden die höheren Beugungsordnungen der am Objekt gebeugten Strahlung, die von ihrer Intensität her ohnehin schon schwächer als der Nullstrahl sind, durch die Folie zusätzlich durch elastische und inelastische Streuung in ihrer Intensität geschwächt, so daß der erzeugte Kontrast entsprechend schwach ist.

Das erste in dem o.g. Aufsatz beschriebe Prinzip, die Ausnutzung der phasenschiebenden Wirkung eines externen elektrischen Potentials, wird in der US 5 814 815 wieder aufgegriffen. Dort wird zur Verschiebung der Phase des Nullstrahles gegenüber den höheren Beugungsordnungen der am Objekt gebeugten Strahlung eine elektrostatische Einzellinse eingesetzt. Aufgrund der kleinen räumlichen Abstände der verschiedenen Beugungsordnungen müssen zur Herstellung der Einzellinse mikro-mechanische Fabrikationsverfahren angewendet werden. Der Aufbau der ringförmigen elektrostatischen Einzellinse in zentraler Lage und die dafür erforderlichen Haltestrukturen bewirken eine Ausblendung von Beugungsinformationen. Ein weiterer Nachteil ist, daß die Einzellinse freitragend aufgebaut sein muß und somit sehr schwer realisierbar ist. Weitere Schwierigkeiten bereitet die Isolierung der Mittelelektrode, da streng darauf geachtet werden muß, daß in Strahlnähe keine isolierenden Materialien vorhanden sind, die durch den Elektronenstrahl aufgeladen werden. Und wie bei der oben beschriebenen Variante mit der Lochfolie kann auch hier die kleine zentrale Bohrung sehr rasch verschmutzen und durch Kontamination zuwachsen.

Ziel der vorliegenden Erfindung ist es daher, ein Elektronenmikroskop anzugeben, mit dem die Erzeugung von leicht interpretierbaren Phasenkontrastbildern möglich ist und das keine hinsichtlich der Herstellung und einer dauerhaften Funktionserhaltung kritischen Bauteile aufweist. Insbesondere sollen keine frei tragenden Strukturen, d.h. Strukturen, die über dünne Haltestege gehalten werden, die den Bereich des für die Erzeugung der Abbildung erforderlichen Strahlquerschnittes überbrücken, erforderlich sein.

Dieses Ziel wird durch ein Elektronenmikroskop mit den Merkmalen des Anspruches 1 gelöst. Vorteilhafte Ausführungsformen der Erfindung ergeben sich aus den Merkmalen der abhängigen Ansprüche.

Beim erfindungsgemäßen Elektronenmikroskop wird der Phasenkontrast sehr ähnlich zur Erzeugung des Phasenkontrastes in der Lichtmikroskopie erzeugt. Das Beleuchtungssystem des Elektronenmikroskopes erzeugt in einer zur abzubildenden Objektebene fouriertransformierten Ebene eine ringförmige Beleuchtungsapertur. Wie in der Phasenkontrast Lichtmikroskopie erfolgt demzufolge die Beleuchtung des abzubildenden Objektes mit einem hohlkegelförmigen Strahl. In der zur Objektebene fouriertransformierten Ebene oder einer dazu konjugierten Ebene ist ein phasenschiebendes Element angeordnet, das der am Objekt in ungebeugten Strahlung, d.h. dem Nullstrahl, gegenüber der am Objekt in höheren Beugungsordnungen gebeugten Strahlung eine Phasenverschiebung erteilt. Gleichzeitig läßt das phasenschiebende Element die Phase der am Objekt in höhere Beugungsordnungen gebeugten Strahlung, die in radialer Richtung näher an der optischen Achse als der Nullstrahl verlaufen, unbeeinflußt oder beeinflußt diese nur geringfügig.

Beim erfindungsgemäßen Transmissions-Elektronenmikroskop wird wie beim Phasenkontrast in der Lichtmikroskopie von dem phasenschiebenden Element die am Objekt ungebeugte Strahlung gegenüber der am Objekt gebeugten Strahlung eine Phasenverschiebung erteilt. Die am Objekt in höhere Beugungsordnungen gebeugte Strahlung, die in der Ebene des phasenschiebenden Elementes in radialer Richtung näher an der optischen Achse verläuft als die am Objekt ungebeugte Strahlung, wird hingegen vom phasenschiebenden Element nicht beeinflußt. Ein entsprechendes phasenschiebendes Element kann daher ringförmig mit einer zentralen Öffnung ausgebildet sein. Ein solches ringförmiges phasenschiebendes Element kann demzufolge an seinem Außenumfang gefaßt sein, so daß keine freitragenden oder nahezu freitragenden Strukturen erforderlich sind. Dabei liefert es sogar elektronenoptische Vorteile, wenn das phasenschiebende Element oder eine Haltestruktur des phasenschiebenden Elementes die gegenüber dem Nullstrahl in radialer Richtung weiter von der optischen Achse entfernt liegenden höheren Beugungsordnungen ausblendet. Denn dadurch wird der negative Einfluß von außerachsialen Aberrationen des Objektivs reduziert.

Weiterhin vorzugsweise beeinflußt das phasenschiebende Element nicht nur die Phase des Nullstrahls sondern schwächt über eine entsprechende Absorption gleichzeitig die Intensität des Nullstrahls. Durch die dadurch erzielbare Intensitätsanpassung zwischen dem Nullstrahl und den höheren Beugungsordnungen wird insgesamt eine Kontrastverbesserung erzielt. Bei einer Kombination des phasenschiebenden Elementes mit einer Aperturblende läßt sich ein sehr stabiler Aufbau des phasenschiebenden Elementes realisieren. Die zur optischen Achse abgebeugte Strahlung höherer Ordnung kann ungehindert durch die zentrale Öffnung des phasenschiebenden Elementes hindurchtreten, während die von der optischen Achse in radialer Richtung weg gebeugte Strahlung ausgeblendet wird. Durch diese Ausblendung geht jedoch keinerlei Information verloren, da der bezüglich der optischen Achse um 180° gedrehte Beleuchtungsstrahl die komplementäre Information zu den ausgeblendeten Beugungsordnungen enthält.

Ein entsprechendes phasenschiebendes Element ist technologisch einfach zu realisieren. Durch ihren ungehinderten Durchtritt durch das phasenschiebende Element erfährt die Information tragende gebeugte Strahlung höherer Ordnung weder durch den Aufbau des phasenschiebenden Elementes noch durch dessen Halterung eine negative Beeinflussung, wie eine Abschwächung oder zusätzliche Phasenverschiebung. Außerdem wird keine in bestimmte Raumrichtungen gebeugte Strahlung vollständig durch Haltestrukturen ausgeblendet. Das entsprechende phasenschiebende Element kann vielmehr rotationssymmetrisch zur optischen Achse ausgebildet sein.

Weiterhin werden kleine Löcher im phasenschiebenden Element, durch die der Primärstrahl hindurchtreten muß; vermieden. Negative Einflüsse von ansonsten bei kleinen Löchern auftretenden Kontaminationseffekten sind dadurch weitgehend ausgeschlossen. Und da nur die keine Information über das Objekt tragende Information nullter Beugungsordnung durch das phasenschiebende Element hindurch tritt, gleichen sich Variationen der Phasenverschiebung aufgrund lokaler Dickeschwankungen des phasenschiebenden Elementes statistisch aus.

Bei einer Ausführungsform der Erfindung ist das phasenschiebende Element als Ringelektrode ausgebildet, dessen elektrostatisches Potential variierbar ist.

Bei einer alternativen Ausführungsform der Erfindung ist das phasenschiebende Element als ringförmige Folie ausgebildet, die an einem massiven Träger aufgenommen ist. Sowohl die ringförmige Folie als auch der massive Träger weisen jeweils eine senkrecht zur optischen Achse ausgerichtete Öffnung auf, wobei der Öffnungsdurchmesser der ringförmigen Folie kleiner als der Öffnungsdurchmesser des massiven Trägers ist. Der massive Träger kann dann gleichzeitig als Aperturblende zur Ausblendung der von der optischen Achse weg gebeugten höheren Beugungsordnungen dienen.

Zur Erzeugung der ringförmigen Beleuchtungsapertur ist vorzugsweise in einer zur Objektebene konjugierten Ebene ein Ablenksystem vorgesehen. Bei dieser Ausführungsform wird die ringförmige Beleuchtungsapertur zeitlich sequentiell durch Variation des Ablenkwinkels erzeugt.

Eine alternative Erzeugung der ringförmigen Beleuchtungsapertur ist auch durch eine entsprechende Blende mit einer zentralen Abschattung im Beleuchtungsstrahlengang möglich. Weiterhin ist es insbesondere bei thermischen Emittern als Elektronenquelle möglich, das unterheizte Kathodenbild (Hohlstrahl), das bereits eine ringförmige Emissionsverteilung mit einem schwachen zentralen Maximum aufweist, in die vordere Brennebene der Kondensor-Objektiv-Einfeldlinse abzubilden und den zentralen Emissionsfleck auszublenden, um die ringförmige Bleuchtungsapertur zu erzeugen.

Weitere Einzelheiten und Vorteile der vorliegenden Erfindung werden nachfolgend anhand der in den Figuren dargestellten Ausführungsbeispiele näher erläutert. Im einzelnen zeigen:
- Fig. 1: eine Prinziskizze eines erfindungsgemäßen Transmissions-Elektronenmikroskopes im Schnitt;
- Fig. 2: einen Ausschnitt aus der Prinzipskizze in Figur 1;
- Fig. 3a und 3b: zwei Ausführungsbeispiele für phasenschiebende Elemente in Form einer Folie in einer geschnittenen perspektivischen Ansicht;
- Fig. 4 und 5: zwei Ausführungsbeispiele für phasenschiebende Elemente als Ringelektrode ausgebildet in einer geschnittenen perspektivischen Ansicht.

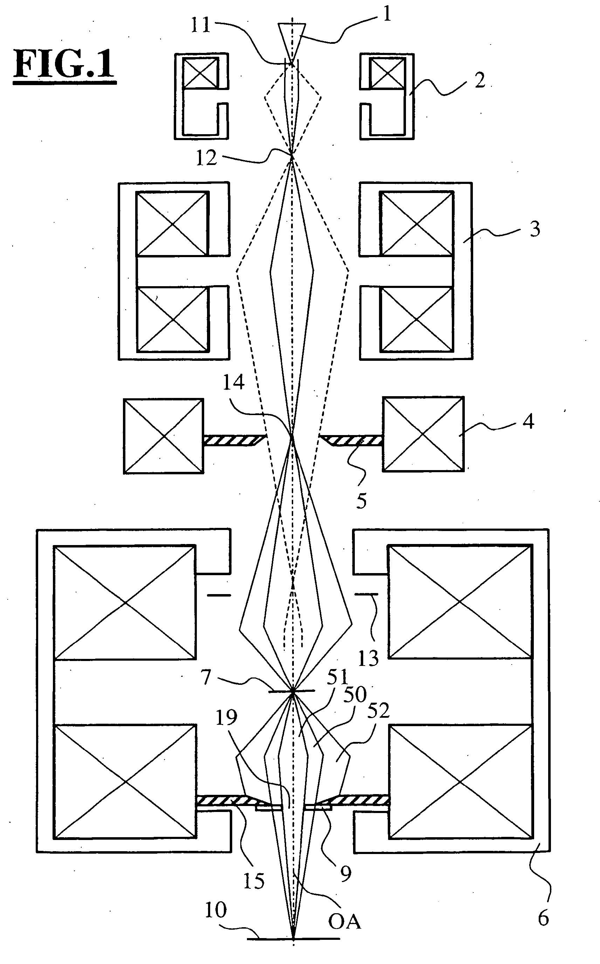

Das in der Figur 1 dargestellte Transmissionselektronenmikroskop weist einen Strahlerzeuger (1) und einen insgesamt dreistufigen Kondensor (2, 3, 6) auf. Der Strahlerzeuger (1) ist vorzugsweise eine Feldemisssionsquelle oder ein Schottky-Emitter. Die erste Kondensorlinse (2) erzeugt ein reelles Bild (12) des Crossovers (11) des Strahlerzeugers (1). Dieses reelle Crossover Bild (12) wird von der nachfolgenden zweiten Kondensorlinse (3) reell in die quellenseitige Brennebene (13) der dritten Kondensorlinse (6) abgebildet. Die dritte Kondensorlinse (6) ist eine sogenannte Kondensor-Objektiv-Einfeldlinse, deren Vorfeld als Kondensorlinse und deren Rückfeld als Objektivlinse dient und bei der die Objektebene (7) in der Mitte des Polschuhspaltes der Kondensor-Objektiv-Einfeldlinse (6) liegt. Durch die Abbildung des Crossovers (11) des Teilchenerzeugers (1) in die quellenseitige Brennebene (13) der Kondensor-Objektiv-Einfeldlinse (6) wird die Objektebene (7) durch einen parallel zur optischen Achse ausgerichteten Teilchenstrahl ausgeleuchtet. Der entsprechende Beleuchtungsstrahlengang ist in der Figur 1 gestrichelt dargestellt.

In der quellenseitigen zur Objektebene (7) konjugierten Ebene ist eine Feldblende (5) und ein Ablenksystem (4) oder der Kipppunkt eines Doppelablenksystems angeordnet. Durch das Ablenksystem (4) wird der Teilchenstrahl zu jedem zu einem Objektpunkt konjugierten Punkt (14) in der Ebene der Feldblende (5) um gleiche Winkel gekippt. Durch diese Auslenkung oder Kippung des Teilchenstrahles wird eine entsprechende Kippung des Teilchenstrahles in der Objektebene (7) erzeugt. Durch eine Beaufschlagung des Ablenksystems (4) in zwei zueinander senkrechten Richtungen entsprechend einer Sinusfunktion in einer Richtung und einer Cosinusfunktion in der dazu senkrechten Richtung, mit zeitlich konstanter und identischer Amplitude in beiden zu einander senkrechten Richtungen, resultiert in der Objektebene (7) ein rotierender Strahl der einer zeitlich sequentiellen hohlkegelförmigen Beleuchtungsapertur entspricht. Durch Einstellung der Amplitude der durch das Ablenksystem (4) erzeugten Ablenkung ist der Innendurchmesser der ringförmigen Beleuchtungsapertur bestimmt und einstellbar. Der Ringdurchmesser der ringförmigen Beleuchtungsapertur ist hingegen durch den Abbildungsmaßstab bestimmt, mit dem der Crossover (11) des Teilchenstrahlerzeugers (1) in die quellenseitige Brennebene (13) der Kondensor-Objektiv-Einfeldlinse (6) abgebildet ist.

Durch das Rückfeld bzw. Abbildungsfeld der Kondensor-Objektiv-Einfeldlinse (6) wird der Strahlkegel mit zeitlich sequentieller hohlkegelförmiger Beleuchtungsapertur in die Zwischenbildebene (10) fokussiert, so dass in der Zwischenbildebene (10) ein reeles Bild der Objektebene (7) entsteht. In der hinteren, zwischenbildseitigen Brennebene (15) der Kondensor-Objektiv-Einfeldlinse ist im Bereich der zentralen Öffnung einer Aperturblende (8) das ringförmige phasenschiebende Element (9) aufgenommen. Dieses ringförmige phasenschiebende Element hat eine große zentrale Öffnung (19) - mit einem Durchmesser von einigen 10 µm, vorzugsweise mindestens 30 µm -, durch die die gegenüber der ungebeugten Strahlung (Nullstrahl) (50) in Richtung auf die optische Achse (OA) abgebeugte Strahlung höherer Ordnung (51) ungehindert hindurchtreten kann. Gleichzeitig erteilt das phasenschiebende Element (9) der am Objekt ungebeugten Strahlung, also dem Nullstrahl (50), eine Phasenverschiebung von vorzugsweise π/2. In der Zwischenbildebene (10) findet eine Überlagerung des phasenverschobenen Nullstrahls (50) mit der in Richtung auf die optische Achse gebeugten Strahlung (51) statt. Diejenigen am Objekt gebeugten höheren Beugungsordnungen (52), die in der Ebene des phasenschiebenden Elementes (9) gegenüber der ungebeugten Strahlung weiter entfernt von der optischen Achse verlaufen, werden hingegen von der Aperturblende (8) absorbiert.

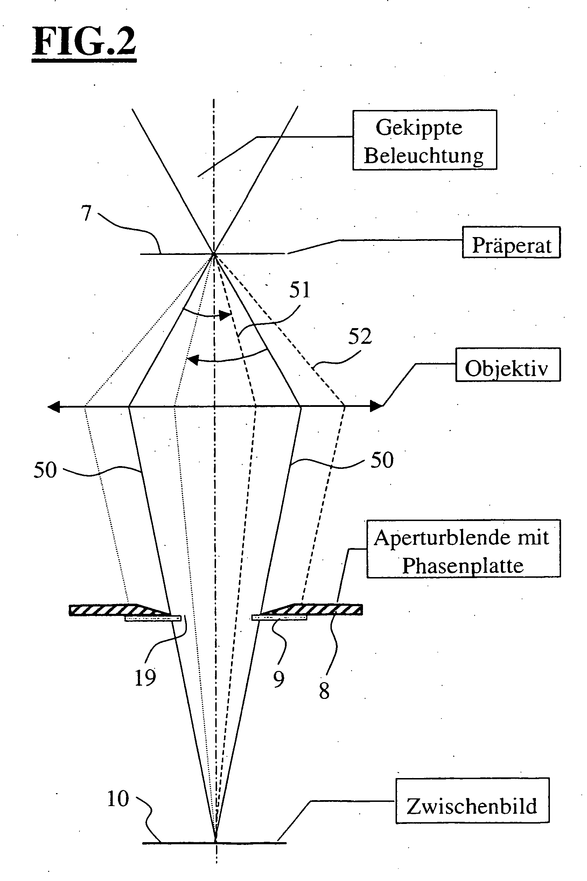

Hinsichtlich der Lagen der verschiedenen Beugungsordnungen relativ zum phasenschiebenden Element (9) und der sich daraus ergebenden Funktionsweise der erfindungsgemäßen Anordnung sei auf Figur 2 verwiesen. Dort sind als durchgezogene Linien jeweils die beiden Nullstrahlen (50), gestrichelt jeweils die beiden plus ersten Beugungsordnungen und punktiert jeweils die beiden minus ersten Beugungsordnungen der beiden eingezeichneten Beleuchtungsstrahlen eingezeichnet. Sowohl die plus erste als auch die minus erste Beugungsordnung (51), die in der Ebene des phasenschiebenden Elementes näher zur optischen Achse als der Nullstrahls verlaufen, treten unbeeinflußt durch die zentrale Öffnung (10) im phasenschiebenden Element (9) hindurch. Die am Präparat ungebeugte Strahlung (Nullstrahl) erfährt am ringförmigen phasenschiebenden Element (9) die gewünschte Phasenverschiebung und die ebenfalls gewünschte Abschwächung, während die beiden achsferneren höheren Beugungsordnungen (52) vollständig von der Blende (8) eliminiert werden.

Wie sich insgesamt anhand der Figuren 1 und 2 verstehen läßt, wird jeder Punkt in der Objektebene (7) mit einem Elektronenstrahl beleuchtet, der eine hohlkegelförmige Beleuchtungsapertur aufweist. Die Spitze des Beleuchtungsstrahlkegels liegt dabei in der Objektebene (7). Das von der Objektebene wieder ausgehende Strahlenbündel mit divergenter hohlkegelförmiger Beleuchtungsapertur wird vom Nachfeld der Kondensor-Objektiv-Einfeldlinse (6) in die Zwischenbildebene (10) abgebildet. Durch Interferenz der durch die zentrale Öffnung (19) des phasenschiebenden Elementes (9) hindurchtretenden höheren Beugungsordnungen (51) mit dem vom phasenschiebenden Element phasenverschobenen Nullstrahl (50) entsteht in der Zwischenbildebene (10) ein Phasenkontrastbild des in der Objektebene (7) angeordneten Präparates. Da jeweils die diametral zueinander gegenüberliegenden Beleuchtungsstrahlen die Beugungsinformation des komplementären Halbraumes liefern, liegt die Beugungsinformation über das Präparat vollständig vor, die Ausblendung der von der optischen Achse weg gebeugten höheren Beugungsordnungen führt lediglich zu einem Intensitätsverlust um einen Faktor ½. Dieser Intensitätsverlust ist jedoch relativ unkritisch und wird durch die übrigen Vorteile der vorliegenden Erfindung überkompensiert.

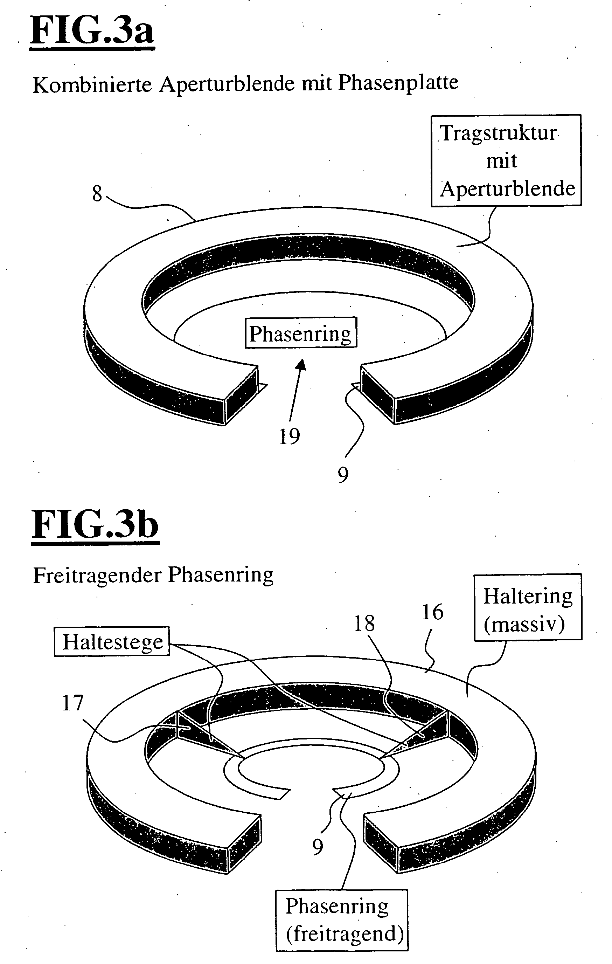

Ein erstes Ausführungsbeispiel für ein phasenschiebendes Element ist in der Figur 3a dargestellt. Es weist eine ringförmige Tragstruktur (8) aus einem elektrisch leitenden Material auf. Die Tragstruktur (8) hat eine zentrale Öffnung (19). Im Bereich der zentralen Öffnung (19) ist an der Tragstruktur (8) eine dünne ringförmige Membran (9) aufgenommen, die geringfügig in die zentrale Öffnung (19) der Tragstruktur (8) hineinragt. Die Tragstruktur (8) dient gleichzeitig als Aperturblende zur Ausblendung der von der optischen Achse weg gebeugten Strahlung höherer Ordnung. Durch den geringen Überstand der Folie und die radiale Anbindung der Folienmembran (9) über den vollen Durchmesser an der Tragstruktur (8) ergibt sich ein mechanisch und elektrisch sehr stabiler Aufbau. Eventuelle Aufladungen der Folie werden dadurch vermieden, daß die Ladungen über die Tragstruktur (8) abfließen können.

Das Ausführungsbeispiel in Figur 3b unterscheidet sich vom Ausführungsbeispiel in Figur 3a lediglich darin, daß das als dünne Membran ausgebildete phasenschiebende Element (9) über zwei dünne Haltestege (17, 18) (ein dritter Haltesteg befindet sich in dem in Figur 3b weggeschnittenen Bereich und ist demzufolge nicht sichtbar) an der Tragstruktur (16) aufgenommen ist. Diese Ausführungsform in der Figur 3b hat gegenüber der Ausführungsform in Figur 3a den Vorteil, daß auch die von der optischen Achse weg gebeugten höheren Beugungsordnungen zur Bildentstehung beitragen können, jedoch auf Kosten einer geringeren Stabilität und eines höheren technischen Aufwandes.

In beiden Ausführungsformen in den Figuren 3a und 3b kann die Membran (9) elektrisch isoliert an der jeweiligen Tragstruktur (8, 16) aufgenommen sein, so daß die Membran gegenüber der Tragstruktur mit einem elektrischen Potential beaufschlagt werden kann. Dadurch kann die phasenschiebende Wirkung variiert werden.

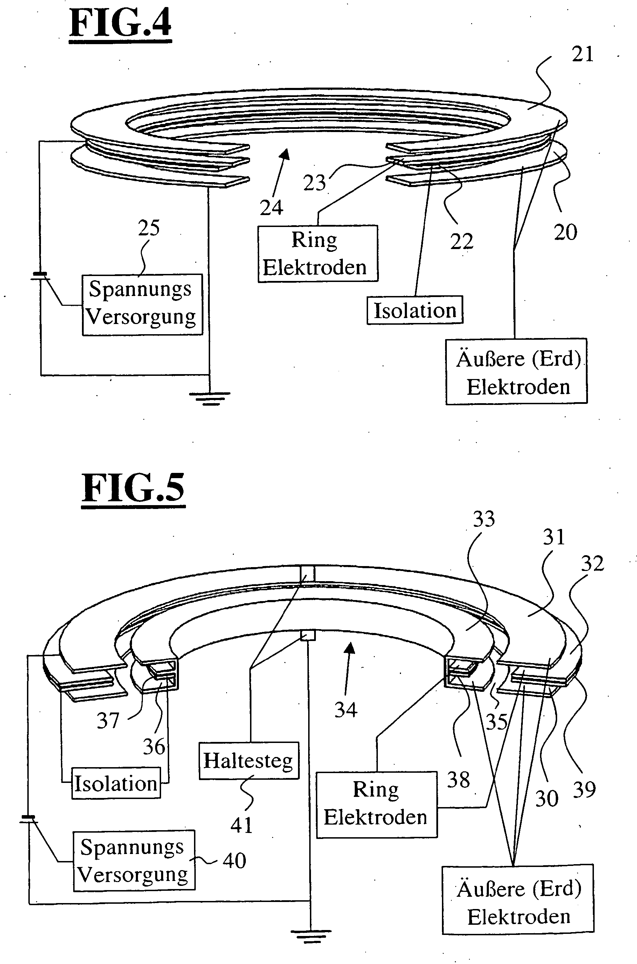

In der Figur 4 ist ein relativ einfaches Ausführungsbeispiel für ein elektrostatisches phasenschiebendes Element dargestellt. Dieses phasenschiebende Element enthält drei koaxial zueinander, in Richtung der optischen Achse hinter einander angeordnete Ringelektroden (20, 21, 23) mit einer kreisförmigen zentralen Öffnung (24). Durch einen Isolator (22) ist die Mittelelektrode (23) gegenüber den beiden äußeren Ringelektroden (20, 21) isoliert. Die beiden äußeren Ringelektroden (20, 21) liegen auf dem identischen Potential, dem Potential des elektronen-optischen Rohres im Bereich des phasenschiebenden Elementes, und die Mittelelektrode (23) kann über eine Spannungsversorgung (25) auf ein gegenüber den äußeren Elektroden (20, 21) unterschiedliches Potential gelegt werden. Da die am Objekt (7) ungebeugte Strahlung (Nullstrahl) näher an der Mittelelektrode (23) verläuft als die in Richtung der optischen Achse gebeugte Strahlung höherer Ordnung, erfährt der Nullstrahl durch die Potentialdifferenz zwischen der Mittelelektrode (23) und den beiden äußeren Elektroden (20, 21) eine Phasenverschiebung, während die in Richtung auf die optische Achse (Mitte der zentralen Öffnung 24) gebeugte Strahlung höherer Ordnung keine oder nur eine geringfügige konstante Phasenverschiebung erfährt.

Auch bei dem Ausführungsbeispiel in Figur 4 dient die Elektrodengeometrie zur Ausblendung der höheren Beugungsordnungen, die vom Objekt von der optischen Achse weg gebeugt worden sind.

Dieses einfache Ausführungsbeispiel für ein elektrostatisches phasenschiebendes Element liefert insbesondere bei Systemen befriedigende Ergebnisse, bei denen der Strahlerzeuger nur eine geringe Beleuchtungsapertur erzeugt, also insbesondere bei Systemen mit Feldemissionsquelle oder Schottky Emitter. Grund dafür ist, daß die Phasenverschiebung als Funktion des Abstandes vom Zentrum der zentralen Öffnung (24) quadratisch zu diesem Zentrumsabstand verläuft. Daraus resultiert, daß zentrumsferne Strahlen eine deutlich stärkere Phasenverschiebung erfahren als zentrumsnahe Strahlen. Innerhalb einer jeden Beugungsordnung ist die Phasenverschiebung demzufolge jedoch nicht konstant sondern nimmt von innen nach außen zu, was insbesondere bei großen Beleuchtungsaperturen Nachteile nach sich zieht. Bei Feldemissionsquellen und Schottky Emittern ist jedoch die Beleuchtungsapertur hinreichend gering, so daß die Variation der Phasenverschiebung innerhalb des Nullstrahles nur wenige Prozent beträgt. Daher ist es möglich, durch Wahl einer geeigneten Potentialdifferenz zwischen der Mittelelektrode (23) und den beiden äußeren Elektroden (20, 21) die gewünschte Phasenverschiebung um π/2 für die ungebeugte Strahlung einzustellen. Die zentrale Öffnung (24) der drei koaxial zueinander angeordneten Elektroden (20, 21, 23) hat dabei einen Innendurchmesser von ca. 50µm und damit technologisch einfach beherrschbare Dimensionen.

Eine weitere, in Figur 5 dargestellte Ausführungsform für ein elektrostatisches phasenschiebendes Element hat gegenüber der Ausführungsform in Figur 4 einen etwas aufwendigeren Aufbau. Wie beim Ausführungsbeispiel in Figur 4 sind auch hier wiederum drei äußere Ringelektroden (30, 31, 39) koaxial angeordnet, von denen die Mittelelektrode (39) über einen Isolator (32) gegenüber den anderen Elektroden isoliert ist. Innerhalb der zentralen Öffnung (34) der drei koaxialen Ringelektroden (30, 31, 39) ist eine ebenfalls ringförmige Abschirmelektrode (33) angeordnet, die in einer die optische Achse enthaltenen Schnittebene ein u-förmiges Profil mit der Öffnung des u nach außen, in Richtung auf die äußeren Elektroden (30, 31, 39) hat. Der Außendurchmesser dieser ringförmigen Abschirmelektrode ist kleiner als der Innendurchmesser der zentralen Öffnung in den beiden äußeren Elektroden (30, 31), so daß zwischen der Abschirmelektrode (33) und den äußeren Elektroden (30, 31) ein ringförmiger Spalt (35) vorgesehen ist. Dieser ringförmige Spalt (35) dient für den Durchtritt des Nullstrahls. Die Abschirmelektrode (33) weist in radialer Richtung eine Ausnehmung (36) auf, in der über einen Isolator (37) eine weitere Ringelektrode (38) aufgenommen ist. Die in der Ausnehmung der Abschirmelektrode (33) angeordnete weitere Ringelektrode (38) steht der mittleren Elektrode (39) der drei äußeren Ringelektroden ( 30, 31, 39) gegenüber.

Bei diesem Ausführungsbeispiel liegen die beiden äußeren Elektroden (30, 31)und die Abschirmelektrode (33) auf dem selben Potential, während die beiden inneren Ringelektroden (38, 39) mittels einer Spannungsversorgung (40) mit einem davon abweichenden Potential beaufschlagbar sind. Diese Potentialdifferenz zwischen den beiden inneren Elektroden (38, 39) und den äußeren Elektroden (30, 31, 33) ist nun wiederum so eingestellt, daß der durch die ringförmige Öffnung (35) hindurchtretende Nullstrahl die gewünschte Phasenverschiebung von π/2 erfährt. Durch die Abschirmelektrode (33) ist gewährleistet, daß im inneren der kreisförmigen Öffnung der Abschirmelektrode (33) das Potential konstant ist und demzufolge die höheren Beugungsordnungen der am Objekt gebeugten Strahlung keinerlei Phasenverschiebung erfahren.

Die Ausführungsform in der Figur 5 ist zwar hinsichtlich ihrer Herstellung aufwendiger als die Ausführungsform in Figur 4, jedoch wird gleichzeitig erreicht, daß die Phasenverschiebung, die der Nullstrahl erfährt, über die Apertur konstant ist und ebenfalls die höheren Beugungsordnungen überhaupt keine Phasenverschiebung erfahren.

Zur Aufnahme der Abschirmelektrode (33) an den beiden äußeren Elektroden (30, 31) können in der Figur 5 nicht dargestellte Haltestege (41) vorgesehen sein. Diese Haltestege wirken sich jedoch nicht nachteilig aus, da sie lediglich den Nullstrahl schwächen und demzufolge keinesfalls für das bestrahlte Objekt spezifische Beugungsinformation eliminieren.

Gegenüber den als Membran ausgebildeten phasenschiebenden Elementen liefern die als Ringelektrode oder Ringelektroden ausgebildeten phasenschiebenden Elemente entsprechend den Ausführungsformen in Figur 4 und 5 den Vorteil, daß die Phasenverschiebung ohne Durchtritt durch ein störendes Material erfolgt und daß sich durch Variation des Potentials zwischen der inneren Ringelektrode/den inneren Ringelektroden und den äußeren Elektroden eine variable Phasenverschiebung einstellen läßt.

## Patentansprüche

1. Transmissions-Elektronenmikroskop mit einer optischen Achse (OA), einem Beleuchtungssystem (1, 2, 3, 4) zur Ausleuchtung eines in einer Objektebene (7) zu positionierenden Objektes mit einem Elektronenstrahl und einem Objektiv (6) zur Abbildung des ausgeleuchteten Objektes, wobei der Elektronenstrahl am Objekt in einen Nullstrahl und höhere Beugungsordnungen aufgespalten wird, wobei in einer von der Objektebene (7) abgewandten Brennebene (15) des Objektivs (6) oder einer dazu konjugierten Ebene ein phasenschiebendes Element (9) angeordnet ist, **dadurch gekennzeichnet, dass** das Beleuchtungssystem derartig ausgebildet ist, dass es im Betrieb in einer zur Objektebene (7) fouriertransformierten Ebene eine ringförmige Beleuchtungsapertur erzeugt und dass das phasenschiebende Element derartig ausgebildet ist, dass es im Betrieb dem Nullstrahl (50) gegenüber der am Objekt in höheren Beugungsordnungen (51) gebeugten Strahlung eine Phasenverschiebung erteilt und dass das phasenschiebende Element (9) derartig ausgestaltet ist, dass es im Betrieb die Phase der am Objekt in höheren Beugungsordnungen (51) gebeugten Strahlung, die in radialer Richtung näher an der optischen Achse als der Nullstrahl (50) verläuft, nicht oder nur geringfügig beeinflußt.

2. Transmissions-Elektronenmikroskop nach Anspruch 1, wobei das phasenschiebende Element (9) oder eine Haltestruktur (8) des selben derartig ausgebildet ist, dass es/sie im Betrieb die gegenüber dem Nullstrahl (50) in radialer Richtung weiter von der optischen Achse (OA) entfernt liegenden höheren Beugungsordnungen (52) ausblendet.

3. Transmissions-Elektronenmikroskop nach Anspruch 1 oder 2, wobei das phasenschiebende Element (9) ringförmig mit einer zentralen Öffnung (19) ausgebildet ist.

4. Transmissions-Elektronenmikroskop nach einem der Ansprüche 1 - 3, wobei das phasenschiebende Element (9) derartig ausgebildet ist, dass es im Betrieb den Nullstrahl (50) in der Intensität abschwächt.

5. Transmissions-Elektronenmikroskop nach einem der Ansprüche 1 - 4, wobei die Elektronenquelle eine Feldemissionsquelle (1) oder ein Schottky Emitter ist.

6. Transmissions-Elektronenmikroskop nach einem der Ansprüche 1 - 5, wobei das phasenschiebende Element eine Ringelektrode (23, 38, 39) aufweist.

7. Transmissions-Elektronenmikroskop nach Anspruch 6, wobei das Potential der Ringelektrode (23, 38, 39) gegenüber dem Umgebungspotential variierbar ist.

8. Transmissions-Elektronenmikroskop nach einem der Ansprüche 1 - 5, wobei das phasenschiebende Element (9) als ringförmige Folie an einem massiven Träger (8, 16) ausgebildet ist, wobei die ringförmige Elektrode (9) und der massive Träger (8, 16) jeweils eine senkrecht zur optischen Achse (OA) ausgerichtete Öffnung aufweisen und wobei der Öffnungsdurchmesser der Folie (9) kleiner als der Öffnungsdurchmesser des Trägers (8, 16) ist.

9. Transmissions-Elektronenmikroskop nach Anspruch 8, wobei die ringförmige Folie (9) gegenüber dem Träger (8, 16) elektrisch isoliert ist.

10. Transmissios-Elektronenmikroskop nach einem der Ansprüche 1 - 9, wobei in einer zur Objektebene (7) quellenseitigen, konjugierten Ebene ein Ablenksystem (4) für eine zeitlich sequentielle Erzeugung der ringförmigen Beleuchtungsapertur angeordnet ist.

11. Transmissions-Elektronenmikroskop nach Anspruch 10, wobei das Ablenksystem (4) derartig ausgebildet ist, dass es im Betrieb eine Ablenkung des Elektronenstrahls in zwei zueinander senkrechten Richtungen erzeugt, und derartig, dass im Betrieb die Ablenkung in einer Richtung sinusförmig und in der dazu senkrechten Richtung cosinusförmig als Funktion der Zeit erfolgt, wobei die Amplitude der sinus- bzw. cosinusförmigen Ablenkung identisch und zeitlich konstant ist.

## Claims

1. Transmission electron microscope having an optical axis (OA), an illumination system (1, 2, 3, 4) for illuminating an object to be positioned in an object plane (7) with an electron beam and an objective (6) for imaging the illuminated object, the electron beam being split at the object into a zero-order beam and higher diffraction orders, a phase-shifting element (9) being arranged in a focal plane (15) of the objective (6) away from the object plane (7) or in a plane conjugate therewith, **characterized in that** the illumination system is designed so that during operation an annular illumination aperture is generated in a plane Fourier-transformed relative to the object plane (7), and **in that** the phase-shifting element is designed so that during operation it imparts a phase shift to the zero-order beam (50) with respect to the radiation diffracted in higher diffraction orders (51) at the object and **in that** the phase-shifting element (9) is configured in such a manner that during operation it does not or only slightly affects the phase of the radiation, diffracted into higher diffraction orders (51) at the object, which extends closer to the optical axis in a radial direction than the zero-order beam (50).

2. Transmission electron microscope according to Claim 1, the phase-shifting element (9) or a holding structure (8) thereof being designed so that during operation it stops out the higher diffraction orders (52) lying further away from the optical axis (OA) in a radial direction than the zero-order beam (50).

3. Transmission electron microscope according to Claim 1 or 2, the phase-shifting element (9) being designed annularly with a central opening (19).

4. Transmission electron microscope according to one of Claims 1 - 3, the phase-shifting element (9) being designed so that during operation it attenuates the intensity of the zero-order beam (50).

5. Transmission electron microscope according to one of Claims 1 - 4, the electron source being a field emission source (1) or a Schottky emitter.

6. Transmission electron microscope according to one of Claims 1 - 5, the phase-shifting element comprising a ring electrode (23, 38, 39).

7. Transmission electron microscope according to Claim 6, the potential of the ring electrode (23, 38, 39) being variable relative to the surrounding potential.

8. Transmission electron microscope according to one of Claims 1 - 5, the phase-shifting element (9) being designed as an annular foil on a solid support (8, 16), the annular electrode (9) and the solid support (8, 16) respectively having an opening aligned perpendicularly to the optical axis (OA) and the opening diameter of the foil (9) being less than the opening diameter of the support (8, 16).

9. Transmission electron microscope according to Claim 8, the annular foil (9) being electrically insulated from the support (8, 16).

10. Transmission electron microscope according to one of Claims 1 - 9, a deflection system (4) for chronologically sequential generation of the annular illumination aperture being arranged in a source-side plane conjugate with the object plane (7).

11. Transmission electron microscope according to Claim 10, the deflection system (4) being designed so that during operation it generates a deflection of the electron beam in two mutually perpendicular directions, and so that during operation the deflection takes place sinusoidally in one direction and cosinusoidally in the direction perpendicular thereto as a function of time, the amplitude of the sinusoidal and cosinusoidal deflections being identical and constant over time.

## Revendications

1. Microscope électronique à transmission, qui présente un axe optique (OA), un système d'éclairage (1, 2, 3, 4) qui éclaire par un faisceau d'électrons un objet placé sur un plan d'objet (7) et un objectif (6) de forme l'image de l'objet éclairé, le faisceau d'électrons étant dissocié sur l'objet en un faisceau neutre et des ordres de diffraction plus élevés, un élément de déphasage (9) étant disposé dans le plan focal (15) de l'objectif (6), plan non tourné vers le plan d'objet (7), ou dans un plan conjugué à ce plan focal, **caractérisé en ce que** le système d'éclairage est réalisé de telle sorte qu'en fonctionnement, une ouverture annulaire d'éclairage soit formée dans un plan de transformée de Fourier par rapport au plan d'objet (7), et **en ce que** l'élément de déphasage est configuré de telle sorte qu'en fonctionnement, il donne au faisceau neutre (50) un déphasage par rapport au rayonnement diffracté sur l'objet en ordres de diffraction (51) plus élevés, et **en ce que** l'élément de déphasage (9) est configuré de telle sorte qu'en fonctionnement, il n'agit pas ou agit peu sur la phase du rayonnement diffracté sur l'objet en ordres de diffraction (51) plus élevés et qui s'étend plus près de l'axe optique dans la direction radiale que le faisceau neutre (50).

2. Microscope électronique à transmission selon la revendication 1, dans lequel l'élément de déphasage (9) ou une structure (8) de maintien de ce dernier sont configurés de telle sorte qu'en fonctionnement, ils suppriment les ordres de diffraction (52) plus élevés situés plus près de l'axe optique (OA) dans la direction radiale que le faisceau neutre (50).

3. Microscope électronique à transmission selon les revendications 1 ou 2, dans lequel l'élément de déphasage (9) a une forme annulaire avec une ouverture centrale (19).

4. Microscope électronique à transmission selon l'une des revendications 1 à 3, dans lequel l'élément de déphasage (9) est configuré de telle sorte qu'en fonctionnement, il réduit l'intensité du faisceau neutre (50).

5. Microscope électronique à transmission selon l'une des revendications 1 à 4, dans lequel la source d'électrons est une source (1) d'émission de champ ou un émetteur Schottky.

6. Microscope électronique à transmission selon l'une des revendications 1 à 5, dans lequel l'élément de déphasage présente une électrode annulaire (23, 38, 39).

7. Microscope électronique à transmission selon la revendication 6, dans lequel le potentiel de l'électrode annulaire (23, 38, 39) par rapport au potentiel ambiant peut être modifié.

8. Microscope électronique à transmission selon l'une des revendications 1 à 5, dans lequel l'élément de déphasage (9) est configuré en film annulaire sur un support massif (8, 16), l'électrode annulaire (9) et le support massif (8, 16) présentant tous deux une ouverture orientée perpendiculairement par rapport à l'axe optique (OA), le diamètre de l'ouverture du film (9) étant plus petit que le diamètre de l'ouverture du support massif (8, 16).

9. Microscope électronique à transmission selon la revendication 8, dans lequel le film annulaire (9) est isolé électriquement par rapport au support massif (8, 16).

10. Microscope électronique à transmission selon l'une des revendications 1 à 9, dans lequel un système (4) de déviation est disposé dans un plan conjugué au plan d'objet (7) du côté de la source pour créer une succession temporelle d'ouvertures annulaires d'éclairage.

11. Microscope électronique à transmission selon la revendication 10, dans lequel le système (4) de déviation est configuré de telle sorte qu'en fonctionnement, il dévie le faisceau d'électrons dans deux directions perpendiculaires l'une à l'autre et de telle sorte qu'en fonctionnement, la déviation s'effectue en fonction du temps sinusoïdalement dans une direction et cosinusoïdalement dans la direction perpendiculaire à la première, l'amplitude de la déviation sinusoïdale et celle de la déviation cosinusoïdale étant identiques et constantes dans le temps.
